## Europäisches Patentamt

## European Patent Office

## Office européen des brevets

(11) Veröffentlichungsnummer: **0 574 812 A2**

# EUROPÄISCHE PATENTANMELDUNG

(21) Anmeldenummer: **93109208.4**

(22) Anmeldetag: **08.06.93**

(51) Int. Cl.⁵: **H03M 1/12**

(30) Priorität: **17.06.92 DE 4219841**

(43) Veröffentlichungstag der Anmeldung:
**22.12.93 Patentblatt 93/51**

(84) Benannte Vertragsstaaten:
**AT CH DE ES FR GB IT LI NL**

(71) Anmelder: **Blaupunkt-Werke GmbH**
**Postfach 77 77 77,**
**Robert-Bosch-Strasse 200**
**D-31132 Hildesheim(DE)**

(72) Erfinder: **Kässer, Jürgen, Dr.**
**Ahornweg 5**
**D-3201 Diekholzen(DE)**

(74) Vertreter: **Eilers, Norbert, Dipl.-Phys.**
**Blaupunkt-Werke GmbH,**
**Patente und Lizenzen,**
**Postfach 77 77 77**
**D-31132 Hildesheim (DE)**

(54) **Verfahren zur Analog-Digital-Wandlung.**

(57) Es wird ein Verfahren zur Analog-Digital-Wandlung von elektrischen Signalen beschrieben, bei dem der Unterschied zwischen den analogen momentanen Signalwert und einem analogen vorausgehenden Signalwert in einem schnellen Analog-Digital-Wandler gewandelt wird und dieser zu dem zwischengespeicherten digitalen vorausgehenden Signalwert hinzuaddiert und der neue Signalwert in einem langsamen hochgenauen Digital-Analog-Wandler in den analogen vorausgehenden Signalwert umgesetzt wird.

EP 0 574 812 A2

Gegenstand des Schutzrechts ist ein neues Verfahren zur Wandlung von analogen, frequenz- oder phasenmodulierten Signalen in entsprechende Digital-Signale und ein Analog/Digital-Wandler, der nach diesem Verfahren arbeitet.

Bei üblichen Analog/Digital-Wandlern besteht keine Vorgabe für Eigenschaften des zu wandelnden Analog-Signals, wenn man davon absieht, daß die Frequenz, mit der sich das Analog-Signal ändern kann, unterhalb der doppelten Grenzfrequenz des A/D-Wandlers liegen muß. Der Aufwand den ein A/D-Wandler erfordert, ist abhängig von der Genauigkeit und Schnelligkeit der gewünschten digitalen Signalwandlung.

Genauigkeit bedeutet hierbei die Anzahl der Bits, die nach der Wandlung den abgetasteten analogen Signalwert darstellen. Im folgenden wird ein 8-Bit-Datenwort für die Darstellung als ungenau angesehen, dagegen ein 14 Bit umfassender digitaler Signalwert als sehr genau. Schnelligkeit bedeutet die Zeit, die ein Wandler benötigt, um ein analoges Signal in z. B. ein 8-Bit-Datenwort umzuwandeln bzw. um einen 14-Bit breiten Signalwert in ein Analog-Signal umzusetzen. Die Umwandlung wird z. B. hier als langsam angesehen, wenn die Einschwingzeit des Wandlers einer Viertel-Periode der Trägerfrequenz des frequenzmodulierten Signals entspricht. Die Umwandlung ist als schnell zu bezeichnen, wenn die Einschwingzeit des Wandlers klein gegenüber der Periode ist.

Der Erfinder suchte nach einer Lösung, den Aufwand bei einer Signalwandlung mit einer vorgegebenen Genauigkeit zu reduzieren und erkannte, daß sich diese Aufgabe dann lösen läßt, wenn man weitere Eigenschaften bei dem zu wandelnden Analog-Signal vorschreibt, d. h. wenn man den Einsatzbereich der Wandler einengt, z. B. auf frequenz- oder phasenmodulierten Träger. Hierbei ist die Frequenz-Bandbreite des Signals begrenzt und klein gegenüber der Trägerfrequenz. Bei diesen Trägern läßt sich die Änderung des Signals durch die Frequenz- oder Phasenmodulation in eine schnelle vom Träger herrührende und in eine langsame von der Modulation herrührende Änderung aufspalten. Die Wandlung bewirkt eine Mischung der Modulation ins Basisband (mit versetzter Abtastung). Die von der Modulation herrührenden Änderungen stellen sich dabei als komplexe Größe dar.

Die Aufgabe, den Aufwand zur Analog/Digital- Wandlung des Real- und/oder des Imaginärteils der Modulation zu vermindern, läßt sich lösen, wenn diese gemäß dem Verfahren nach Anspruch 1 erfolgt. Die Auswertung der beiden Signalanteile erfolgt dann in einem an sich bekannten Auswerteprozessor.

A/D-Wandler, die nach diesem Verfahren arbeiten, sind in den nebengeordneten Ansprüchen näher gekennzeichnet.

Anhand der Zeichnung werden zwei Ausführungsbeispiele der Erfindung näher erläutert. Dabei stellen

Fig. 1  das Blockschaltbild eines ersten erfindungsgemäßen A/D-Wandlers, der ein konjugiert komplexes Signal liefert,

Fig. 2  das Blockschaltbild eines zweiten erfindungsgemäßen A/D-Wandlers

dar.

In beiden Figuren ist das Eingangssignal für den Schaltungsaufbau ein Träger mit der Zwi- schenfrequenz $\omega$ eines UKW-Rundfunkempfängers, der in der Frequenz mit der Größe h(t), nämlich dem Rundfunkprogramm, moduliert ist.

Zu dem Momentanwert des Eingangssignals wird erfindungsgemäß ein früher zwischengespeicherter Wert zugezählt, sodann der analoge Summenwert in einem schnellen ADC geringer Wortlänge in einen digitalen Summenwert umgesetzt und von diesem Summenwert ein früher zwischengespeicherter Signalwert abgezogen. Da das Summensignal sich jeweils aus zwei Signalen mit unterschiedlichen Vorzeichen bildet, ist es klein gegenüber dem Gesamtsignal. Dieser Wandler ist dabei so ausgelegt, daß sein Wandlungsbereich nur einen kleinen Teil der Dynamik des Eingangssignals umfaßt. Für Eingangssignale außerhalb des Wandlungsbereichs zeigt er den jeweiligen Maximalwert an. Die einzelnen Schritte sind dadurch kleiner oder genauso groß wie beim im folgenden beschriebenen D/A-Wandler.

Falls die Schritte des ADC und DAC gleich groß sind, gilt folgendes Beispiel: Ist der Gesamtbereich des zu wandelnden Eingangssignals 0 bis 5 V und die Wandelgenauigkeit von 12 bit gefordert, so entspricht eine einzelne Wandlerstufe rd. 1,22 mV. Der Eingangs-ADC mit z. B. 6 bit Wortlänge könnte einen Eingangsbereich von rd. 64 . 1,22 mV = rd. 78 mV abdecken.

Da beim Einschalten des Wandlers der Zwischenspeicher leer ist, entspricht der erste zwischengespeicherte Wert entweder dem vollen Momentanwert des Eingangssignals oder dem vollen Aussteuerungsbereich des ADC. Im weiteren Verfahrensablauf wird dann zu diesem Wert jeweils der Wert der Differenz addiert oder subtrahiert, so daß nach einigen Schritten der exakte Wert des Eingangssignals vorliegt. Dadurch ergibt sich trotz der geringen Wortlänge des ADC letztlich ein hochgenauer Signalwert im Zwischenspeicher, der an den Auswerteprozessor weitergeleitet wird.

Der im Zwischenspeicher vorhandene digitale Signalwert wird außerdem in einer Rückführschleife von einem langsamen aber hochgenauen Digital- Analog-Wandler in das am Schaltungseingang benötigte zweite analoge Signal umgesetzt.

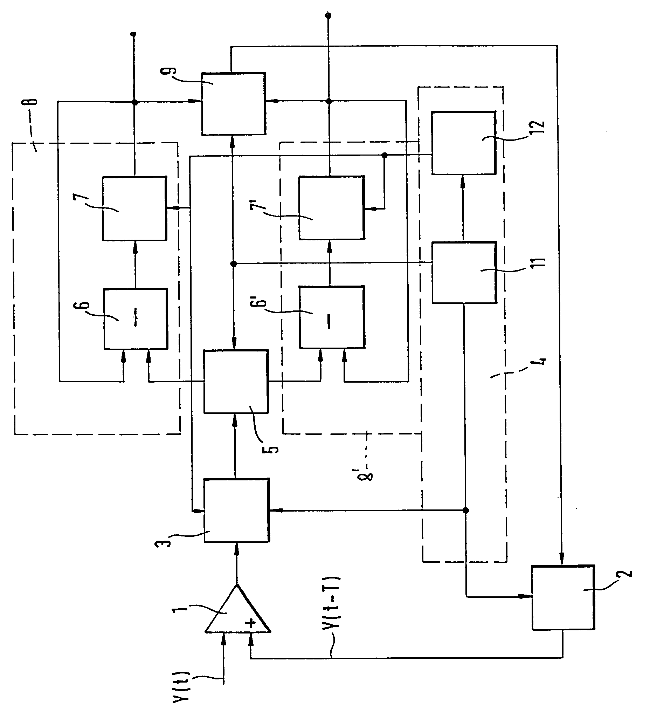

In Fig. 1 ist das Blockschaltbild eines ADC wiedergegeben, der nach diesem Verfahren arbeitet und beide komplexen Teilsignale für einen nachgeschalteten Auswerteprozessor zur Verfügung stellt.

Dem Eingangssignal Y wird in einem Addierer 1 das analoge Ausgangssignal eines langsamen, hochgenauen Digital-Analogwandlers 2 hinzuaddiert und das verbleibende analoge Summensignal in einem schnellen A/D-Wandler 3 in einen digitalen Wert umgesetzt. Im Ausgang des A/D-Wandlers 3 liegt ein von einem Steuerwerk 4 geschalteter Umschalter 5, der den Ausgang des A/D-Wandlers 3 abwechselnd mit dem aus dem Subtrahierer 6 und dem Zwischenspeicher 7 gebildeten Rechenwerk 8 und mit dem aus einem weiteren Subtrahierer 6' und einem Zwischenspeicher 7' gebildeten Rechenwerk 8' umschaltet. Die Ausgänge dieser Rechenwerke 8 und 8' werden von einem zweiten Umschalter 9 abwechselnd synchron mit dem Umschalter 5 an den Eingang des Digital-Analogwandlers 2 gelegt.

Daneben werden die Ausgangssignale der beiden Rechenwerke 8 und 8' direkt auf die zugeordneten Eingänge der digitalen Tiefpässe 10, 10' geleitet. Das Ausgangssignal der Tiefpässe steht zur weiteren Verwendung im System zur Verfügung.

Die beiden Wandler 2 und 3 und die beiden Umschalter werden synchron mit den

$$\frac{4}{4\sqrt{\ }+1}$$

fachen ($\sqrt{\ }$ = 0, 1, 2) der Zwischenfrequenz vom Taktgeber 11 im Steuerwerk 4 angesteuert. Der interne Arbeitstakt der Rechenwerke 8 und 8' wie auch der des A/D-Wandlers 3 ist groß gegenüber dem Wandlertakt und wird vom Taktgeber 12 im Steuerwerk 4 bestimmt.

Während einer Wandlung erfolgt folgender Ablauf:
ADC 3 erhält Aufforderung "wandeln".
Wandelergebnis und Inhalt von Speicher 7 bzw. 7' wird im Subtrahierer 6 bzw. 6' voneinander abgezogen, und das Ergebnis wird in 7 bzw. 7' abgelegt.
Inhalt von 7 bzw. 7' wird an Tiefpaß 10 und DAC 2 weitergeleitet. DAC 2 wandelt.
Nach Ablauf von

$$\frac{4\sqrt{\ }+1}{4}$$

Perioden des Trägers bezogen auf die letzte A/D-Wandlung ergeht die nächste Aufforderung "wandeln" an ADC 3 7 und 7' sowie 6 und 6' vertauschen die Rollen usw.

Beträgt z. B. die momentane Frequenzabweichung 75 kHz und die Abtast/Trägerfrequenz 10,7 MHz und soll die Dynamik 20 dB und das Basisbandsignal 60 dB S/N aufweisen, so ergibt sich unter Berücksichtigung des Gewinns an S/N für das Basisbandsignal durch das der Wandlung folgende Tiefpaßfilter: der ADC sollte etwa 6 bit Wortlänge und der DAC 12 bit Wortlänge haben.

**Patentansprüche**

1. Verfahren zur A/D-Wandlung eines trägermodulierten Eingangssignals,
dadurch gekennzeichnet,
daß die Summe aus dem analogen Momentanwert des Eingangssignals ($Y_n$) und einem analogen, durch digitale Zwischenspeicherung um einen vorgegebenen Phasenwinkel des Trägers verzögerten, früheren Momentwert ($Y_{n-1}$) gebildet und diese Summe in einem schnellen A/D-Wandler 3 geringer Wortlänge in ein digitales Signal umgewandelt wird, daß das Ausgangssignal des A/D-Wandlers (3) um den zwischengespeicherten früheren digitalen Momentanwert ($Y_{n-1}$) verringert wird und dieser neue Digitalwert als digitaler Momentanwert ($Y_n$) zwischengespeichert wird und daß dieser digitale Momentanwert ($Y_n$) einerseits der nachfolgenden Auswerteschaltung (10) und andererseits einem langsamen hochgenauen D/A-Wandler (2) zur Erlangung des verzögerten analogen Momentanwertes für die Summenbildung mit dem neuen anlogen Momentanwert ($Y_{n+1}$) im nächsten Arbeitstakt zugeführt wird.

2. A/D-Wandler für in Quadratur frequenz- oder phasenmodulierte analoge Signale,
gekennzeichnet durch
- einen Addierer" (1), dessen ersten Eingang das analoge Signal ($Y_n$) zuführbar ist,
- einen dem Addierer nachgeschalteten schnellen A/D-Wandler (3) geringer Wortlänge,
- zwei parallel liegende Rechenwerke (8, 8'), die über einen ersten Umschalter (5) wahlweise mit dem Ausgang des A/D-Wandlers (3) verbindbar sind,
- einen langsamen, genauen D/A-Wandler (2), dessen Eingang über einen zweiten Umschalter (9) wahlweise mit dem Ausgang des einen oder anderen Rechenwerks (8, 8') verbindbar ist und dessen Ausgang mit dem zweiten Eingang des Addierers (1) verbunden ist,
wobei jedes Rechenwerk (8, 8') aus einer Subtrahierstufe (6, 6') und einem Zwischenspeicher (7, 7') besteht, deren Ausgänge einerseits den Ausgang des A/D-Wandlers bilden und andererseits jeweils mit dem einen Eingang der Subtrahierstufe (6, 6') verbunden ist, während der andere Eingang der Addierstufe (6, 6') den Eingang des Rechenwerkes (8, 8') bildet.

3. A/D-Wandler nach Anspruch 2,
dadurch gekennzeichnet,
daß der Phasenwinkel zwischen zwei Abtastwerten $(4\nu + 1) \times \frac{\pi}{2}$ beträgt, wobei $\nu = 0, 1, 2$ ist.